# EUROPEAN PATENT SPECIFICATION

(11) **EP 1 367 403 B1**
(45) Date of publication and mention of the grant of the patent: **09.04.2008**
(21) Application number: 03447122.7
(22) Date of filing: 23.05.2003
(51) Int. Cl.: G01R 31/30

(54) **A method for detecting faults in electronic devices, based on quiescent current measurements**
Verfahren zum Detektieren von Fehlern in elektronischen Bauteilen, basierend auf Ruhestrom-Messungen
Procédé pour détecter des défauts dans des dispositifs électroniques, basé sur des mesures du courant de repos

(30) Priority: 23.05.2002 EP 02447094
(43) Date of publication of application: 03.12.2003
(73) Proprietor: Q-Star Test N.V., 8200 Brugge (BE)
(72) Inventor: Manhaeve, Hans, 8200 Sint-Michiels (Brugge) (BE); De Pauw, Piet, 9700 Oudenaarde (BE)
(74) Representative: Van Malderen, Joëlle

(56) References cited:
- US-A- 5 889 409
- MAXWELL P ET AL: 28 September 1999 (1999-09-28), 1999, WASHINGTON, DC, USA, INT. TEST. CONFERENCE, USA, PAGE(S) 738 - 746 , XP002293605 ISBN: 0-7803-5753-1 * abstract; figures 3a,3b,4 * Section 3 "Setting Test Thresholds"; pages 740-743

## Description

### Field of the invention

The present invention is related to methods for testing micro-electronic devices, such as CMOS devices, by monitoring the 'quiescent current' I_{DDQ}, for a set of test vectors applied to the device under test.

### Prior art

I_{DDQ} monitoring is a widely applied technique for fault detection in micro-electronic devices. A device-under-test (DUT) is subjected to a predefined series of test vectors, which are basically digital inputs, applied to the DUT at every pulse of the operational clock frequency. The DUT receives a supply current, generated by a supply voltage V_{DUT}. The switching action of the DUT, in most cases related to an 'active' (rising or falling) edge of the clock signal, is accompanied by a sharp peak in the supply current, which can reach levels in the order of amps or higher. After such a peak, the current returns to a low level (typically not more than 10mA), called the 'quiescent current' I_{DDQ}. This level is representative of the quality of components on the DUT. I_{DDQ} levels must remain within narrow limits for given DUT operating conditions (temperature, voltage): in particular a sharp (vector related) rise of the I_{DDQ} is indicative of component failures.

Existing I_{DDQ} monitors are based on this basic principle : these monitors measure the I_{DDQ} level, compare it to a predefined level, and deliver a pass/fail signal, indicating whether the DUT is operating properly or not. Most monitors allow additional features, such as the output of the I_{DDQ} value, the measurement of current signatures, or the assessment of delta-I_{DDQ} values. This means that subsequent I_{DDQ} values are subtracted, and compared to a reference value for this delta value.

A problem with these standard techniques, in particular the fixed reference, is that I_{DDQ} levels can vary from one device to the other, even between devices of the same type. This makes it difficult to define a fixed reference level for a given device type : it may be possible that for some individual devices, the reference is closely approached or even exceeded by the measured I_{DDQ} levels, even though no error occurs on the tested device. The same goes for delta I_{DDQ} values, which may be higher for a device which has, on average, a higher I_{DDQ} level, than for a device of the same type, with a lower average I_{DDQ}. A solution to overcome the above mentioned problems could be to widen the acceptance criteria. However, this approach has the disadvantage of losing device screening efficiency with as a result that bad parts may not be properly identified as such.

Modern Integrated Circuits are heading into the deep-submicron area in terms of component size. This is leading to an increase in background leakage current. The result is that the I_{DDQ} is composed of this large, non-defect-related background current, and a small defect-related current. For deep submicron IC technologies, the current caused by an IC defect (short, bridging fault, open, gate oxide leakage,.....) in many cases could become very small, e.g. below 1 µA. On the other hand, when comparing one IC to the other, the variation in off state current of the different transistors on the IC, is large.

These variations in off state leakage current, are due to process fluctuations, which affect to a large extent all transistors on the IC. Examples are gate length definition, doping concentration under the gate,... For a deep submicron IC process (e.g. 0.13 (um CMOS), used to fabricate an IC with a large number of transistors (1 million of transistors or more), the variation in IC off state leakage current can be orders of magnitude larger than the leakage current caused by a single IC defect.

This makes it impossible for deep submicron circuits to use absolute leakage current levels, in order to separate "good IC's" from "IC's with a defect".

The most relevant prior art can be found in:
■ Y. Okuda, Eigen Signatures for Regularity-Based IDDQ testing, Proceedings of the VLSI Test Symposium 2002, pp 289-294 (ISBN 0-7695-1570-3)
■ P. Maxwell et al, Current Ratios: A Self-Scaling Technique for Production IDDQ Testing, Proceedings of the International Test Conference ITC'99, paper 28.4, pp 738-746
■ B. Kruseman et al, The Future of Delta-IDDQ Testing, Proceedings of the International Test Conference ITC'2001, pp 101-110
Patent document US 5889409 discloses a method for detecting defects in a semiconductor device by determining the ratio of the quiescent current of the device to the quiescent current of a small sample of the device, representative of the whole device.

### Summary of the invention

The present invention is related to a method according to claim 1.

Said pass or fail decision is preferably made on the basis of whether or not said result of said division is lying in a range of values comprising said relative I_{DDQ} reference.

Said relative I_{DDQ} reference may be a vector-related reference. Said vector-related reference may be obtained by the following steps :
- Taking a random production sample of micro-electronic devices of the same type,
- For each device of the sample: measuring the I_{DDQ} value for a given reference test vector and measuring the I_{DDQ} value for each of the other I_{DDQ} test vectors,
- For each device of the sample: calculating the relative I_{DDQ} value of each I_{DDQ} measurement, by dividing each measurement by the I_{DDQ} value related to the chosen reference vector,
- For each I_{DDQ} vector, for all devices of the sample: determining the mean and the sigma of the relative I_{DDQ} values,
- For each I_{DDQ} vector, for all devices of the sample : omitting all outlying relative I_{DDQ} measurements,
- For each I_{DDQ} vector : determining the mean and the sigma of the relative I_{DDQ} values without the outlying relative I_{DDQ} measurements, thereby obtaining said vector-related reference.

Said relative I_{DDQ} reference may also be 1, in which case the acceptance range could be [0.9; 1.1].

According to a particular embodiment, said relative I_{DDQ} reference is derived from a graph showing the maximum measured I_{DDQ} level as a function of the minimum measured I_{DDQ} level, for a number of micro-electronic devices.

According to a preferred embodiment, the measured value is also compared to an absolute (specification) reference and the pass or fail decision is a combined result of both comparisons.

### Brief description of the drawings

Fig. 1 is a graph comprising absolute I_{DDQ} current values for three devices, for a number of test vectors.

Fig. 2a, 2b and 2c show the vector-to-first-vector I_{DDQ} ratios (relative I_{DDQ} values) for the three devices of figure 1.

Fig. 3 shows absolute I_{DDQ} levels for 20 'good' devices of a given test lot.

Fig. 4 shows the vector-to-first-vector I_{DDQ} ratios of the twenty devices of figure 3, as a function of the device number, for a number of test vectors (each curve represents one test vector).

Fig. 5 shows the vector-to-first-vector I_{DDQ} ratios of the twenty devices of figure 3, as a function of vector number (each curve represents one device).

Fig. 6 represents a zoomed-in view of figure 5.

Fig. 7 represents the min-max curve of a batch of devices, showing the maximum I_{DDQ} level as a function of the minimum I_{DDQ} level, every dot representing one device of the batch.

Fig. 8 shows the graph of figure 7, without outlier points.

Fig. 9 shows a number of outlier points of figure 7, indicating failing devices.

Fig. 10 is equally a min-max graph of a batch of devices.

### Detailed description

The present invention is related to a method for assessing I_{DDQ} measurements in a new way. The method is referred as 'relative I_{DDQ}'. Of a series of I_{DDQ} measurements, taken in relation to a series of test vectors, the ratio of each measured value to a reference or to a previous value is calculated, and assessed with respect to a reference value, for example 1. In addition the measured values are preferably also compared against a specification related limit. In this way, devices are rejected either because they contain a failure or because they do not meet the specification requirements.

This method is independent of a fixed reference of the I_{DDQ} level. Differences in I_{DDQ} level, which are due for example to high background current, but which are not an indication of component failure on a particular DUT, are not detected as such. Preferably, variations between subsequent I_{DDQ} measured values on a DUT are also sufficiently limited to be able to use this method. This is mostly true, as a consequence of the so called 'Matching Theory', which is related to a phenomenon which is increasingly applicable in new micro-electronic devices and is exploited in most analogue circuit designs.

The increase in the number of transistors per IC results in a better matching of the IC leakage currents in the different states of the IC. This effect results in a reduced I_{DDQ} variation from vector to vector, for a single IC.

However, this degree of matching can not be obtained between a component on one device, and a similar component on another device. Therefore, the difference in I_{DDQ} level between test vectors on the same device, tends to become smaller and smaller, so that the 'relative I_{DDQ}' is closer and closer to 1. Any abrupt deviation from this value immediately indicates a failure. The advantage of the relative approach can be understood by considering the following example. A batch of good IC devices may have I_{DDQ} levels ranging from 10µA to 300µA. An absolute I_{DDQ} acceptance limit should therefore be put at at least 300µA, meaning that the total defect-related I_{DDQ} current of a device under test, i.e. the leakage current plus the actual defect current, must exceed 300µA before a fail signal is given. Smaller defect currents remain undetected. One could devise a system wherein an acceptance limit is introduced which is dependent on the tested device, but it would be difficult to define such a limit before knowing whether the device is good or bad.

With the relative method, each I_{DDQ} level is divided by for example the I_{DDQ} of a given vector, e.g. the first test vector. When the matching theory is applicable, the levels of these relative I_{DDQ} values will be close to 1, for every device of the batch.

Suppose that for a first test vector, one device draws an I_{DDQ} level of 10µA and another draws an I_{DDQ} of 100µA, both being good devices. Suppose that a second test vector activates a fault in the first device, resulting in a fault-indicating level of 15µA in said first device, while non-fault indicating levels - for this device - are within the range of 9-11µA. An absolute acceptance level for this type of device should be at least 100µA (given the second device), so that the faulty 15µA would go undetected. The relative approach according to the invention would reveal a relative I_{DDQ} level of 1.5, which would be immediately detected, as it exceeds the normal acceptance range of 0.9 to 1.1. This illustrates the capabilities of the relative approach.

The method of the invention is equally applicable for obtaining a so-called 'signature' relative I_{DDQ} measurement. This may be the case when the matching theory does not apply, for example in a device containing both digital and analog parts. In this case, the measured current may be a combination of leakage (from the digital part) and active current (from the analog part), where the active current is a function of the applied test vector. This would mean that for some vectors, a low I_{DDQ} should be regarded as 'good', while for other vectors, a high acceptance level should be taken into account. This can be incorporated into the relative I_{DDQ} measurement by determining a vector dependent relative I_{DDQ} reference, or 'golden device' reference, as explained in more detail hereafter.

Two particular embodiments are to be noted in terms of the way in which relative I_{DDQ} value is calculated:
- 'vector-to-vector' : wherein each I_{DDQ} measured value is divided by the previous I_{DDQ} value,
- 'vector-to-first-vector' : wherein each I_{DDQ} measured value is divided by the I_{DDQ} of the first vector applied.

### Description of particular embodiments

### 1. relative IDDQ close to 1

The following formulas illustrate the calculation of relative IDDQ values when the matching theory applies, i.e. when the IDDQ ratio, for example in a vector-to-first-vector scheme, approaches 1 for a good device.

*Applied notations :*
I_{DDQ}_x == absolute I_{DDQ} value for measurement x
R_xy == relative I_{DDQ} value for measurement x in relation to measurement y
D_xy == delta I_{DDQ} value for measurement x in relation to measurement y
*For a good device:*
I_{DDQ}_1
I_{DDQ}_2 = I_{DDQ}_L + D_21
I_{DDQ}_3 = I_{DDQ}_2 + D_32 = I_{DDQ}_1 + D_21 + D_32
I_{DDQ}_4 = I_{DDQ}_3 + D_43 = I_{DDQ}_1 + D_21 + D_32 + D_43
   .
   .
I_{DDQ}_n = I_{DDQ}_n-1 + D_nn-1 = I_{DDQ}_1 + D_21 + D_32 + D_43 + . . + D_nn-1

For a device with high leakage currents and taken into consideration the matching theory, then I_{DDQ}_x >> D_xy and SUM(D_xy) ~ 0 if sufficient measurements are taken.
From a relative perspective:
R_11 = I_{DDQ}_1 / I_{DDQ}_1
R_21 = I_{DDQ}_2 / I_{DDQ}_1 = (I_{DDQ}_1 + D_21) / I_{DDQ}_1 = 1 + (D_21 / I_{DDQ}_1)
R_31 = I_{DDQ}_3 / I_{DDQ}_1 = (I_{DDQ}_1 + D_21 + D_32) / I_{DDQ}_1 = 1 + ((D_21+ D_32) / I_{DDQ}_1)
   .
   .
R_n1 = I_{DDQ}_n / I_{DDQ}_1 = (I_{DDQ}_1 + D_21 + D_32 + D_43 + .. + D_nn-1) / I_{DDQ}_1
= 1 + ((D_21+ D_32 + D_43 + .. + D_nn-1) / I_{DDQ}_1)
Starting from the same premises: I_{DDQ}_x >> D_xy and SUM(D_xy) ~ 0, then Dxy / I_{DDQ}_x << 1 and SUM(D_xy) / I_{DDQ_X} - 0, resulting in the fact that for a good device R_xy - 1.
The same remains valid if vector to vector ratios are taken instead of the vector to first vector ratio as in the example.
In the extreme case I_{DDQ}_1 is the vector with minimum leakage. In that case SUM(D_xy)max = I_{DDQ_MAX} - I_{DDQ_MIN} = D_xy max. Then, given that the condition I_{DDQ}_x >> D_xy is fulfilled then R_xy - 1, within certain limits, for example R_xy between 0.9 and 1.1.
*For a bad device -* vector 3 being the one activating the defect:
I_{DDQ}_1
I_{DDQ}_2 = I_{DDQ}_1 + D_21
I_{DDQ}_3 = T_{DDQ}_2 + D_32 + I__{DEFECT}
= I_{DDQ}_1 + D_21 + D_32 + I__{DEFECT}
I_{DDQ}_4 = I_{DDQ}_3 + D_43
= I_{DDQ}_1 + D_21 + D_32 + D_43 + I__{DEFECT}
.
.
I_{DDQ}_n = I_{DDQ}_n-1 + D_nn-1
= I_{DDQ}_1 + D_21 + D_32 + D_43 + . . + D_nn-1 + I__{DEFECT} For a device with high leakage currents and taken into consideration the matching theory, then I_{DDQ}_x >> D_xy and SUM(D_xy) ~ I__{DEFECT} if sufficient measurements are taken and assuming a single defect.
From a relative perspective:
R_11 = I_{DDQ}_1 / I_{DDQ}_1
R_21 = I_{DDQ}_2 / I_{DDQ}_1
= (I_{DDQ}_1 + D_21) / I_{DDQ}_1 = 1 + (D_21 / I_{DDQ}_1)
R_31 = I_{DDQ}_3 / I_{DDQ}_1
= (I_{DDQ}_1 + D_21 + D_32 + I__{DEFECT}) / I_{DDQ}_1
= 1 + ((D_21+ D_32) / I_{DDQ}_1) + (I__{DEFECT} / I_{DDQ}_1)
   .
   .
R_n1 = I_{DDQ}_n / I_{DDQ}_1
= (I_{DDQ}_1 + D_21 + D_32 + D_43 + .. + D_nn-1 + I__{DEFECT}) / I_{DDQ}_1
= 1 + ((D_21+ D_32 + D_43 + .. + D_nn-1) / I_{DDQ}_1) + (I__{DEFECT} / I_{DDQ}_1)
Starting from the same premises: I_{DDQ_X} >> D_xy and SUM(D_xy) ~ 0, then Dxy / I_{DDQ_X} << 1 and SUM(D_xy) / I_{DDQ_X} ~ 0, resulting in the fact that for the bad device R_xy ~ 1 + (I__{DEFECT} / I_{DDQ}_1).
Depending on the ratio between I_{_DEFECT} and I_{DDQ}_1 a measurement with sufficient resolution and repeatability is required to identify the failure. It is to be noted that for the relative method of the invention, it is mainly the repeatability of the I_{DDQ} measurement which has to be of a high standard, more so than the absolute accuracy of the I_{DDQ} currents.
The same remains valid if vector to vector ratios are taken instead of the vector to first vector ratio as in the example.
In the extreme case I_{DDQ}_1 is the vector with minimum leakage. In that case SUM(D_xy)max = I_{DDQ_MAX} - I_{DDQ_MIN} = D_xy max. Then, given that the condition I_{DDQ}_x >> D_xy is fulfilled then R_xy ~ 1 + ( I__{DEFECT} / I_{DDQ}_1)

### 2. Relative I_{DDQ} signature

The following is a description of the method steps, in case the relative I_{DDQ} is obtained by dividing each I_{DDQ} measured value by a reference value and wherein a vector-related reference is used, i.e. a relative I_{DDQ} signature measurement.

*Preparation of production test:*
- Step one: choose the I_{DDQ} reference test vector. E.g. The first test vector.
- Step two: Determination of the relative I_{DDQ} signature of a defect free IC, relative to the chosen I_{DDQ} test vector (= golden relative I_{DDQ} signature). This procedure includes the determination of the mean and the sigma of the relative I_{DDQ} value for each I_{DDQ} test vector.
- Step three: Determination of the pass/fail criteria for each relative I_{DDQ} vector: E.g. When the pass interval is chosen to be: [Relative I_{DDQ} mean- 3*sigma, Relative I_{DDQ} mean + 3*sigma], then all IC's with one or more relative I_{DDQ} values falling outside this pass interval are considered as fails.

Step two of the above described procedure (Determination of the relative I_{DDQ} signature of a defect free IC) is described hereafter in more detail.
■ Take a random production sample of IC's of the same product: e.g. 100 IC's.
■ For each IC of the sample: Measure the I_{DDQ} value for the chosen reference test vector and measure the I_{DDQ} value for each of the other I_{DDQ} test vectors.
■ For each IC of the sample: Calculate the relative I_{DDQ} value of each I_{DDQ} measurement, by dividing each measurement by the I_{DDQ} value of the chosen reference vector.
■ For each I_{DDQ} vector, for all IC's of the sample: Determine the mean and the sigma of the relative I_{DDQ} value.
■ For each I_{DDQ} vector, for all IC's of the sample: Omit all outlying relative I_{DDQ} measurements (e.g. Outside 3 sigma limits) = removal of the freaks.
■ For each I_{DDQ} vector: Determine the mean and the sigma of the freak free population.
■ This 'mean' and 'sigma' for each I_{DDQ} vector constitute the relative I_{DDQ} values of the golden device.

*Data processing and Pass*/*fail decision during production* test:
- For each manufactured IC (of the same product), all I_{DDQ} measured values are compared against the specification limit and divided by the leakage current value measured with the reference I_{DDQ} test vector.
- Pass/fail decision for each manufactured device, can be made immediately following I_{DDQ} measurements of that device, based on the absolute and relative I_{DDQ} values:
   - Pass = the absolute values of all I_{DDQ} values are below the specification limit and the relative I_{DDQ} values of ALL I_{DDQ} test vectors for the device under test are within the pass interval of the golden device.
   - Fail = at least one absolute I_{DDQ} value is above the specification limit or at least one relative I_{DDQ} value of an I_{DDQ} test vector for the device under test falls outside the pass interval determined for this I_{DDQ} test vector.

The present invention is however related to any method wherein a relative I_{DDQ} is used, i.e. wherein a measured I_{DDQ} value is divided by another I_{DDQ} value, after which the result is compared to a reference for this relative I_{DDQ}. In another embodiment, relative I_{DDQ} values are compared to reference value '1'. According to a special embodiment, each I_{DDQ} measured value, obtained by applying a series of test vectors, is divided by the I_{DDQ} value obtained for the previous test vector. A criteria for acceptance may then be that each relative I_{DDQ} must be within the interval [0.9 ; 1.1], in order for the DUT to pass.

The relative I_{DDQ} approach is an IC test data processing procedure, with the following advantages:
■ Easy to determine pass/fail criteria
■ High accuracy of pass/fail decision
■ Technology independent. Easily applicable to new technologies and new products.
■ Relaxed I_{DDQ} testability requirements: additional sources of leakage currents in the IC are allowed, as long as they are stable in time.
■ During production test: minimal data processing and immediate pass/fail decision.

Applicability to new IC technologies:
■ The relative I_{DDQ} technique can be applied on the new IC technologies, having a larger leakage current than the previous generations.
■ Applicability depends on the accuracy of the I_{DDQ} measurement unit. Higher IC leakage current levels, and smaller transistor sizes require an increased accuracy of the I_{DDQ} monitor.

### Test results

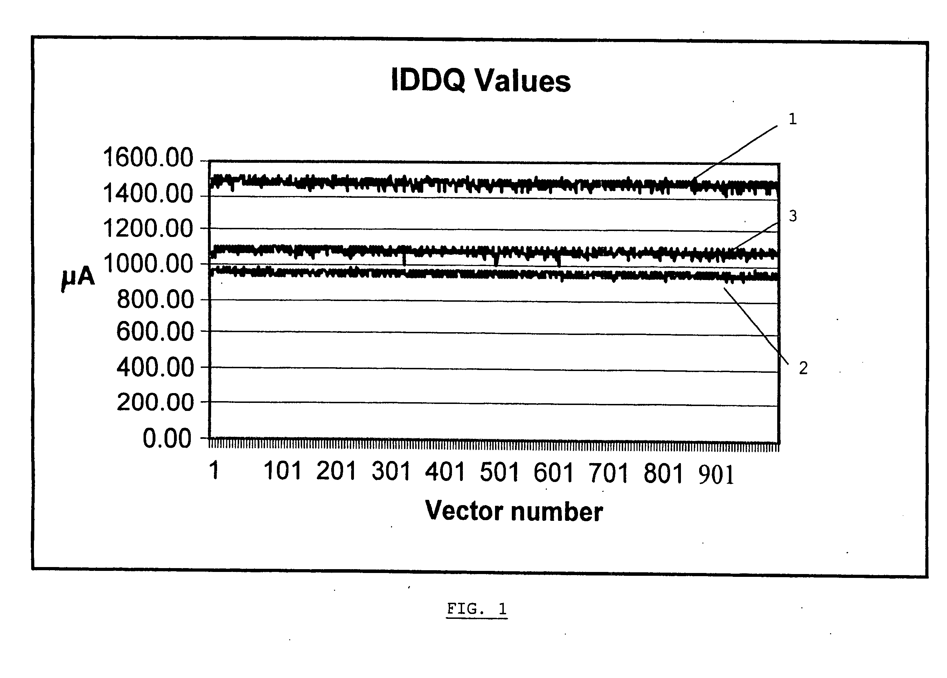

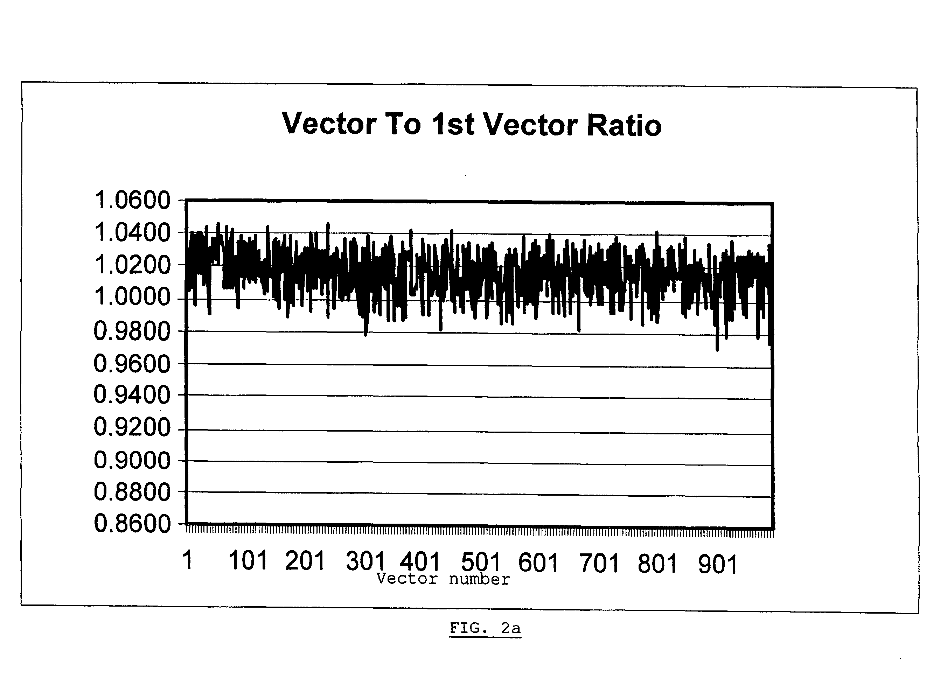

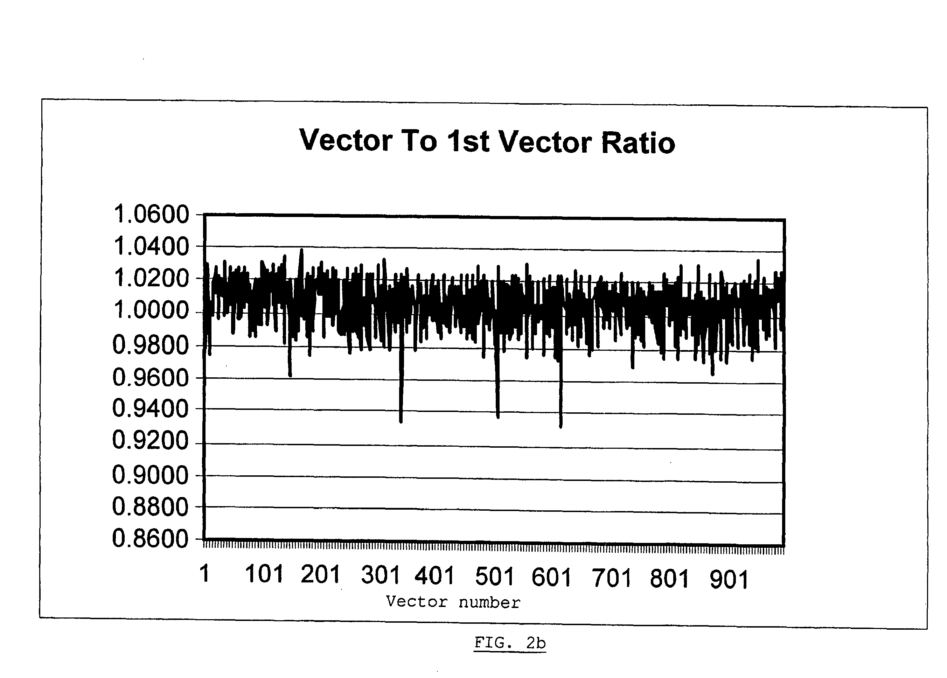

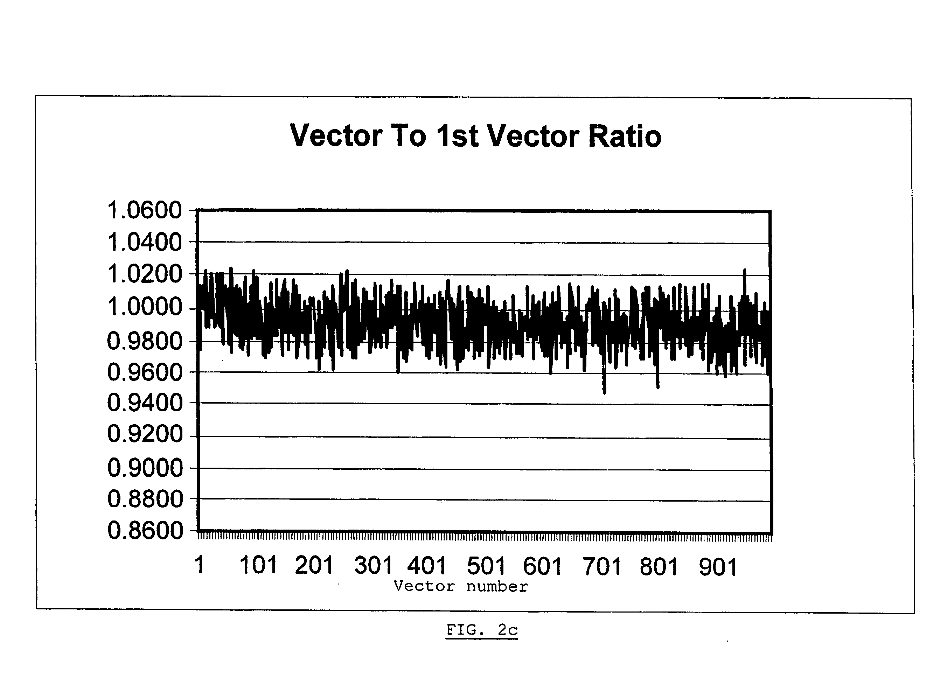

*Example 1* : 3 dies (IC devices) from a same production process. Absolute I_{DDQ} values for these three dies are shown in the graph in figure 1. The X-axis represents a number of test vectors.
Die n°1 (curve 1) has typical readings around 1450µA, die n°2 (curve 2) has measurement results around 950µA and die n°3 (curve 3) has measurement results around 1080µA, as shown in the figure below. These 3 dies are good dies. The graphs in figure 2a, 2b et 2c show respectively the calculated "vector to first vector" ratio for these three dies. It is clear to see that the ratio values are around 1, irrespective of the absolute current drawn by the device.

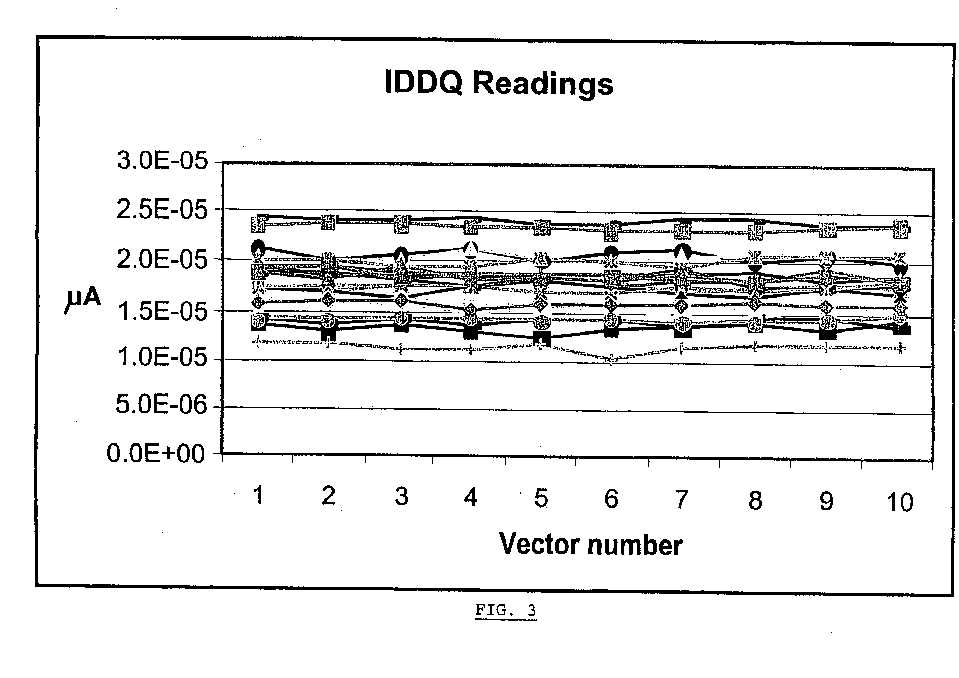

*Example* 2: samples from a production lot with 11420 good and 18 functional bad devices.
Typical readings for the good devices are ranging from 10 to 300µA. The figure 3 below shows the readings of the first 20 good samples from the lot (ranging from 10 to 25µA). The large range of 10-300µA makes it difficult to define a satisfactory absolute 'pass' value for the good devices.

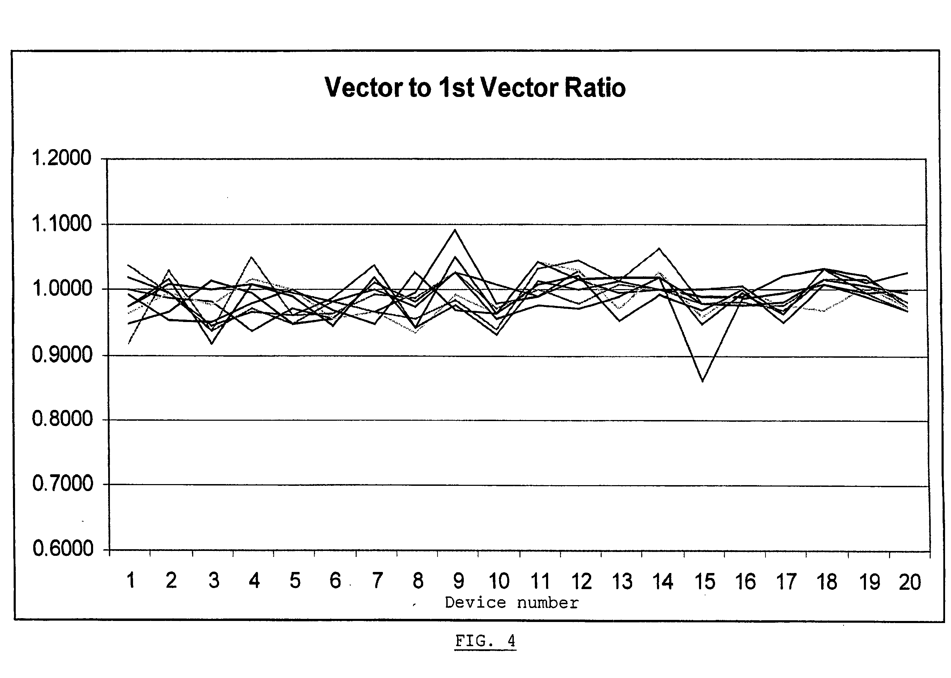

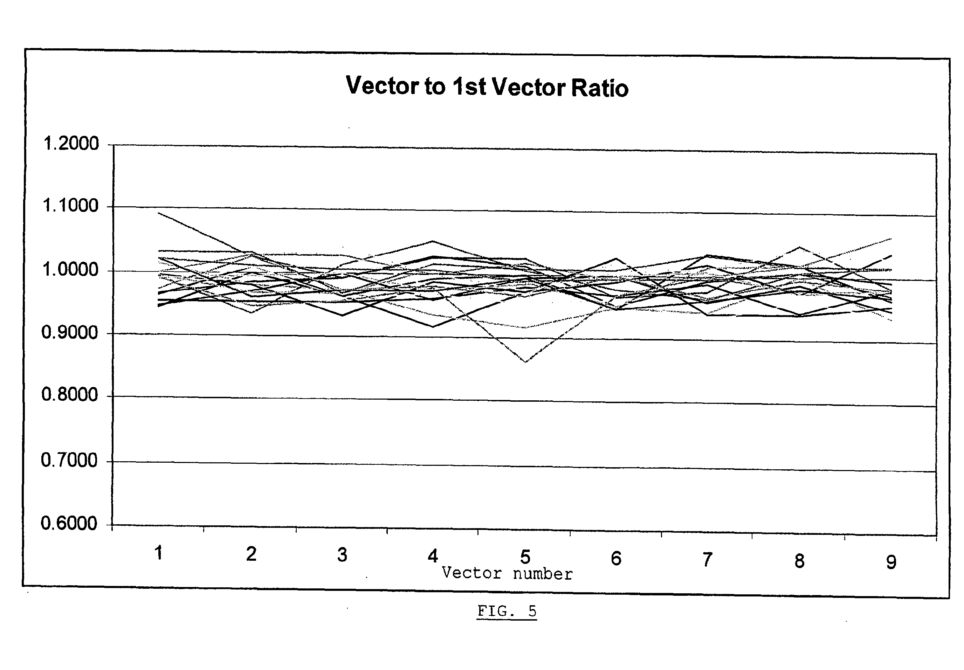

The figures 4 and 5 show the "vector to first vector" ratios for the same devices. Ratio values are ranging from .85 to 1.15. In figure 4, each line represents the ratio values for a particular device (20 devices, 10 I_{DDQ} measurement points per device, resulting in 9 ratio values per device - X axis is device number). In figure 5, each line represents a particular device (X-axis is vector number). Once again, the ratios of the good devices are all relatively close to 1, making it easier to detect a fail.

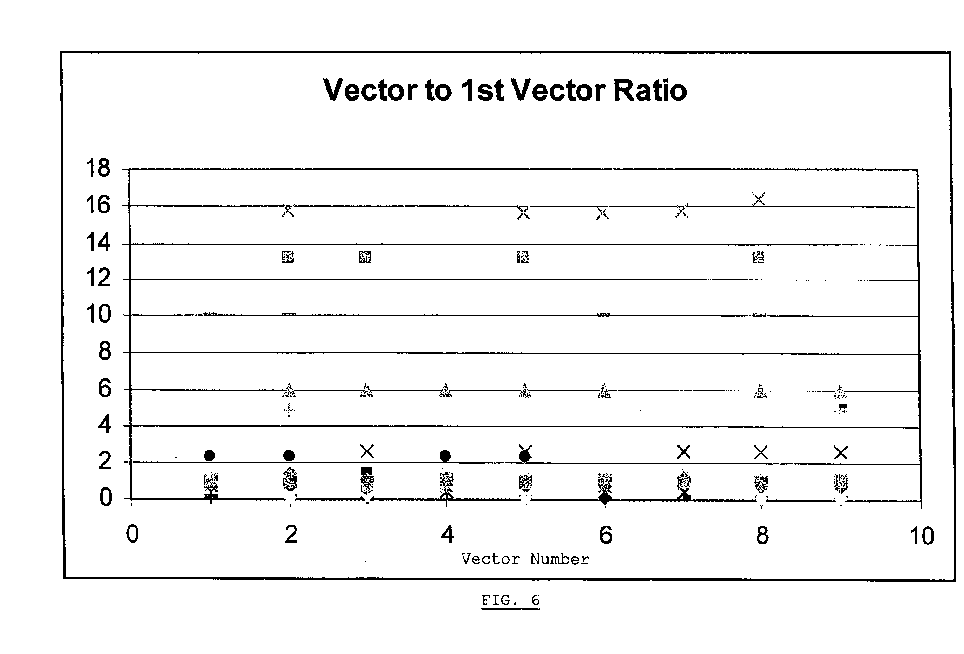

Figure 6 shows the ratio values of 20 bad devices. Each symbol represents a particular device.

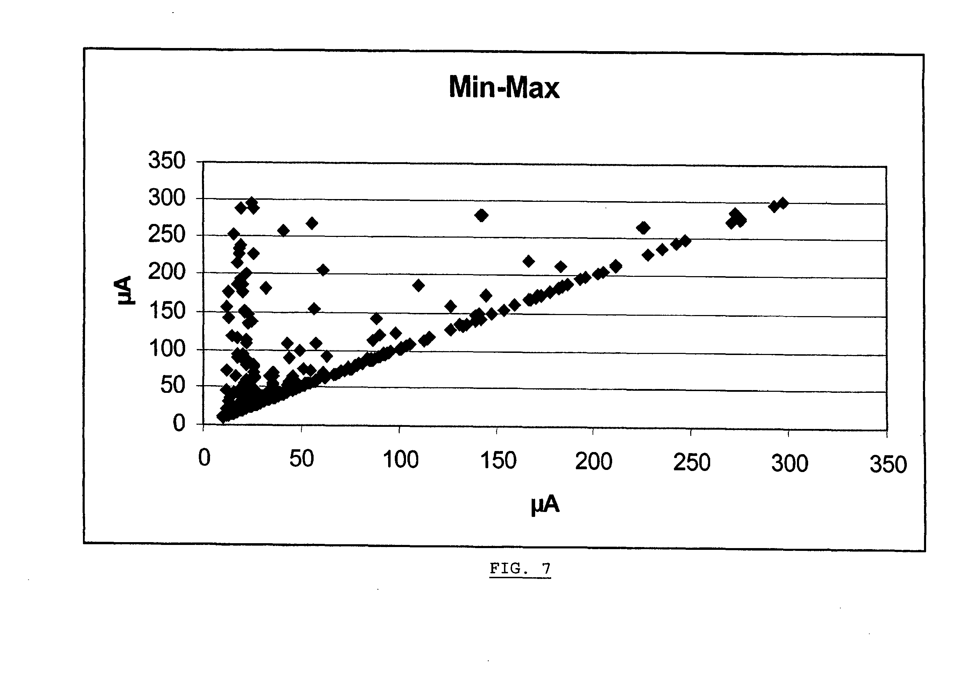

*Example 3* : min-max curves
Figures 7, 8 and 9 are related to the same production lot of example 2 containing 11420 devices with good readings between 10 - 300µA, as well as a number of bad devices. The graphs show the relation between the minimum measured I_{DDQ} value, and the maximum value, for a particular device. Each dot represents one particular device from the batch. For a good device, the min-max curve follows a straight line at 45° with the X-axis. This means that the minimum and maximum value are very close together, indicating that all measured I_{DDQ} values are similar. This is typically true for a device to which the matching theory is applicable. The graphs show that for good devices, a large spread (in this case 10-300µA) is possible from one device to the other, as far as the the absolute I_{DDQ} levels are concerned, while different I_{DDQ} levels measured on the same device differ very little, justifying a relative approach, wherein the relative I_{DDQ} values should be close to 1.

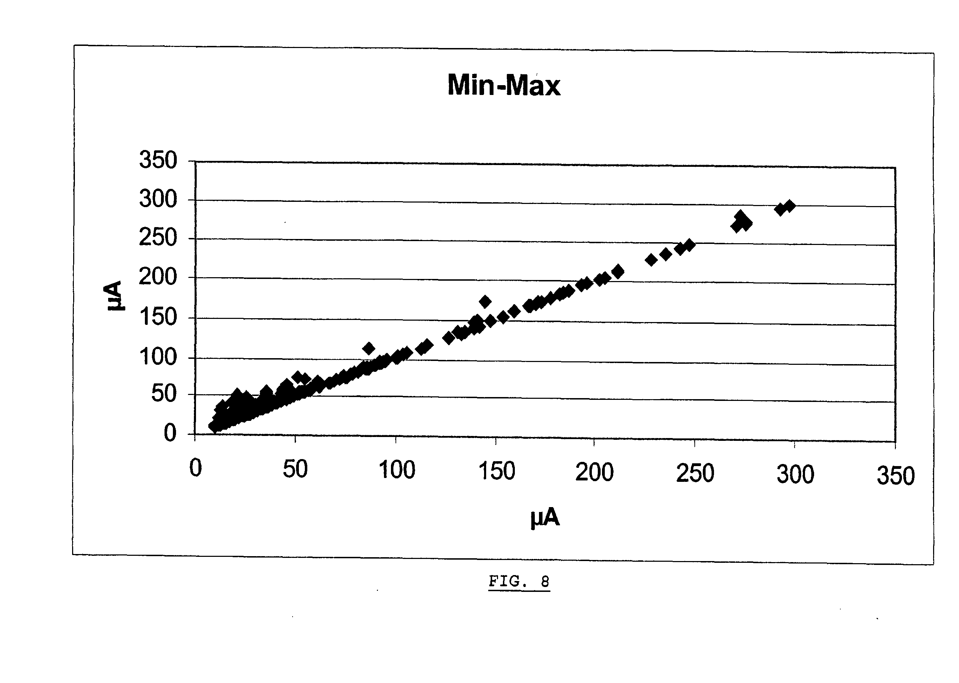

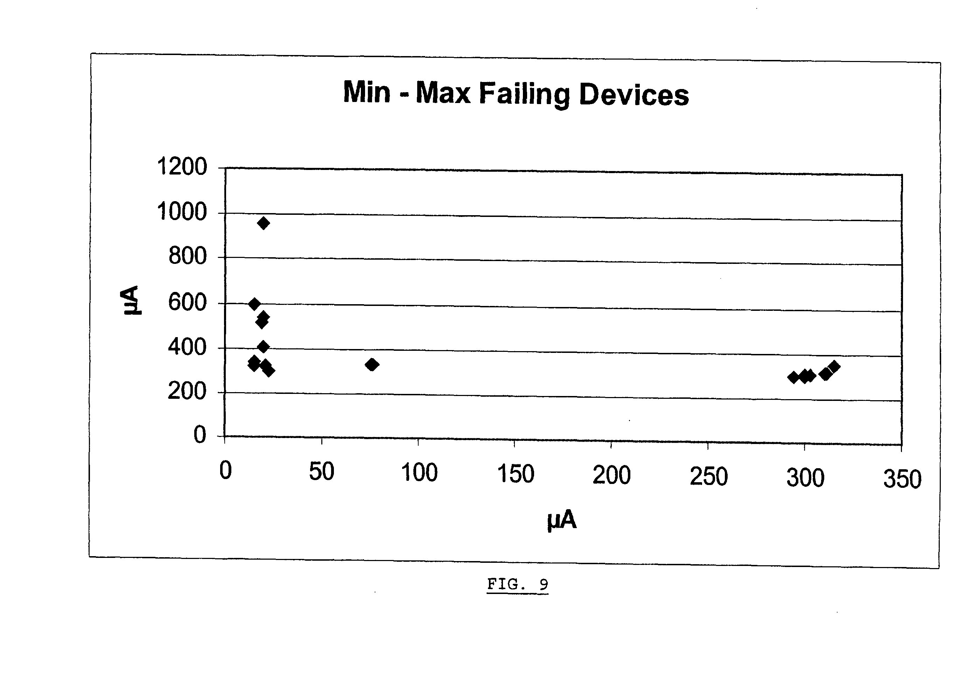

Figure 7 shows the min-max relation of all devices. Figure 8 shows the min-max relation of all good devices after outlier removal. Figure 9 shows the min-max relation of functional bad devices.

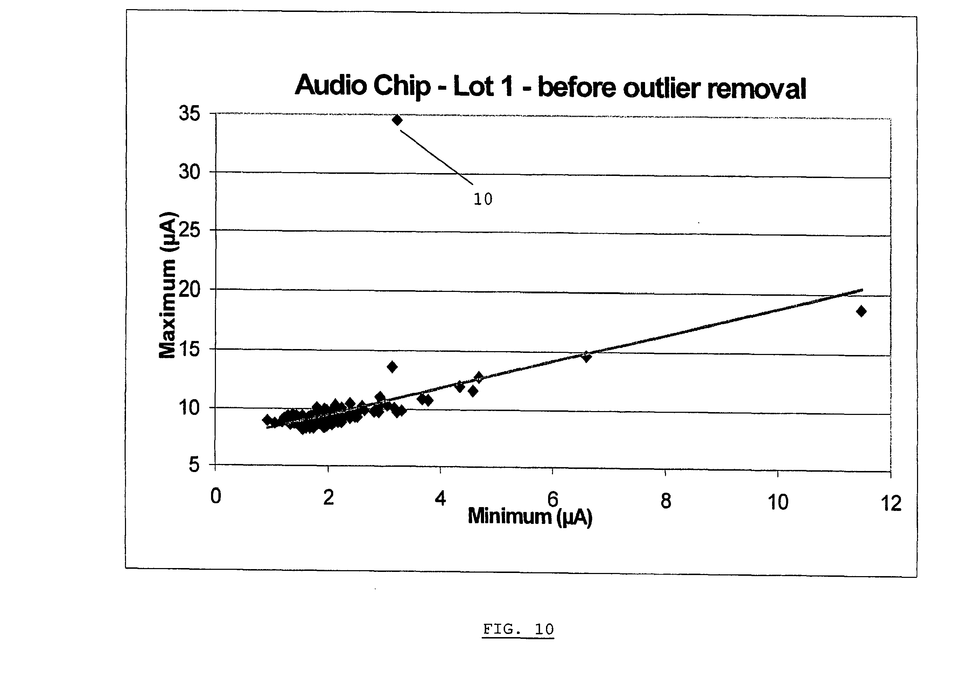

Finally, figure 10 shows the min-max curve for a device which has digital as well as analog parts, and for which the matching theory does not apply. It can be seen that the curve does not follow the 45° line. In particular, the maximum I_{DDQ} value is always significantly larger than the minimum value. However, for good devices, the min-max points still follow a straight line, while for bad devices, the points deviate from this line, such as is the case for point number 10.

For this type of device, the relative approach according to the invention is applicable, as long as the relative I_{DDQ} levels are judged with respect to a reference value which can be derived from the angle of the min-max line for good devices.

In case the min-max curve for a good device follows a curve other than a straight line, a vector-dependent reference should be determined according to the method described above (golden device reference), as no fixed reference can be derived directly from the min-max curve.

## Claims

1. A method for testing a micro-electronic device, comprising the steps of :
- defining a relative I_{DDQ} reference,
- applying a plurality of test vectors to said device,
- measuring for each test vector, the quiescent supply current I_{DDQ}, to said device, wherein each I_{DDQ} measured value is divided by a reference I_{DDQ} value or a previously measured I_{DDQ} value, and wherein the result of said division is compared to said predefined relative I_{DDQ} reference, resulting in a pass or fail decision for said device
**characterized in that** said quiescent supply current I_{DDQ} and said reference I_{DDQ} or previous I_{DDQ} value by which it is divided, are measured on the same device.

2. The method of claim 1, wherein said pass or fail decision is made on the basis of whether or not said result of said division is lying in a range of values comprising said predefined reference.

3. The method of claim 1, wherein said relative I_{DDQ} reference is a vector-related reference.

4. The method of claim 3, wherein said vector-related reference is obtained by the following steps
- Taking a random production sample of micro-electronic devices of the same type,
- For each device of the sample: measuring the I_{DDQ} value for a given reference test vector and measuring the I_{DDQ} value for each of other I_{DDQ} test vectors,
- For each device of the sample: calculating the relative I_{DDQ} value of each I_{DDQ} measurement, by dividing each measurement by the I_{DDQ} value related to the chosen reference vector,
- For each I_{DDQ} vector, for all devices of the sample: determining the mean and the sigma of the relative I_{DDQ} values,
- For each I_{DDQ} vector, for all devices of the sample : omitting all outlying relative I_{DDQ} measurements (10),
- For each I_{DDQ} vector : determining the mean and the sigma of the relative I_{DDQ} values without the outlying relative I_{DDQ} measurements, thereby obtaining said vector-related reference.

5. The method of claim 1, wherein said relative I_{DDQ} reference equals 1.

6. The method of claim 1, wherein said relative I_{DDQ} reference is derived from a graph showing the maximum measured I_{DDQ} level as a function of the minimum measured I_{DDQ} level, for a number of micro-electronic devices.

7. The method of claim 1, wherein the measured value is also compared to an absolute I_{DDQ} reference and the pass or fail decision is a combined result of both comparisons.

8. The method according to claim 1, further comprising the step of comparing the relative I_{DDQ} value to a minimum value, said minimum value being based on the matching theory.

## Patentansprüche

1. Verfahren zum Testen eines mikroelektronischen Bauelements, das folgende Schritte umfasst:
- Definieren einer relativen I_{DDQ}-Referenz,
- Anwenden mehrerer Testvektoren auf das Bauelement,
- Messen des Ruhestroms I_{DDQ} zum Bauelement für jeden Testvektor, wobei jeder I_{DDQ}-Messwert durch einen I_{DDQ}-Referenzwert oder einen bereits gemessenen I_{DDQ}-Wert dividiert und das Ergebnis der Division mit der vorgegebenen relativen I_{DDQ}-Referenz verglichen wird, was zu einer Pass- oder Fail-Entscheidung für das Bauelement führt,
**dadurch gekennzeichnet, dass** der Ruhestrom I_{DDQ} und der I_{DDQ}-Referenzwert oder der vorherige I_{DDQ}-Wert, durch den er dividiert wird, an dem gleichen Bauelement gemessen werden.

2. Verfahren nach Anspruch 1, bei dem die Pass- oder Fall-Entscheidung auf der Grundlage getroffen wird, ob das Ergebnis der Division in einem Wertebereich liegt, der die vorgegebene Referenz umfasst, oder nicht.

3. Verfahren nach Anspruch 1, bei dem es sich bei der relativen I_{DDQ}-Referenz um eine vektorbezogene Referenz handelt.

4. Verfahren nach Anspruch 3, bei dem die vektorbezogene Referenz durch die folgenden Schritte ermittelt wird:
- Entnehmen einer Zufalls-Produktionsstichprobe von mikroelektronischen Bauelementen der gleichen Art,
- für jedes Bauelement der Stichprobe: Messen des I_{DDQ}-Wertes für einen gegebenen Referenz-Testvektor und Messen des I_{DDQ}-Wertes für alle anderen I_{DDQ}-Testvektoren.
- für jedes Bauelement der Stichprobe: Berechnen des relativen I_{DDQ}-Wertes jeder I_{DDQ}-Messung durch Dividieren jeder Messung durch den I_{DDQ}-Wert, der zu dem gewählten Referenzvektor gehört,
- für jeden I_{DDQ}-Vektor bei allen Bauelementen der SCichprobe: Ermitteln des Mittelwertes und des Sigma der relativen I_{DDO}-Werte,
- für jeden T_{DDQ}-Vektor bei allen Bauelementen der Stichprobe: Weglassen aller außerhalb liegenden relativen I_{DDQ}-Messungen (10),
- für jeden I_{DDQ}-Vektor: Ermitteln des Mittelwertes und des Sigma der relativen I_{DDQ}-Werte ohne die außerhalb liegenden relativen I_{DDQ}-Messungen, wodurch die vektorbezogene Referenz ermittelt wird.

5. Verfahren nach Anspruch 1, bei dem die relative I_{DDQ}-Referenz gleich 1 ist.

6. Verfahren nach Anspruch 1, bei dem für eine Anzahl mikroelektronischer Bauelemente die relative I_{DDQ}-Referenz aus einer grafischen Darstellung gewonnen wird, die den maximalen gemessenen I_{DDQ}-Pegel als Funktion des minimalen gemessenen I_{DDQ}-Pegels zeigt.

7. Verfahren nach Anspruch 1, bei dem der Messwert auch mit einer absoluten I_{DDQ}-Referenz verglichen wird und es sich bei der Pass- oder Fail-Entscheidung um ein kombiniertes Ergebnis aus beiden Vergleichen handelt.

8. Verfahren nach Anspruch 1, das des Weiteren das Vergleichen des relativen I_{DDQ}-Wertes mit einem Mindestwert umfasst, wobei der Mindestwert auf der Matching-Theorie basiert.

## Revendications

1. Procédé pour tester un dispositif microélectronique, comportant les étapes consistant à :
- définir une référence I_{DDQ} relative,
- appliquer une pluralité de vecteurs tests audit dispositif,
- mesurer, pour chaque vecteur test, le courant d'alimentation de repos I_{DDQ}, au niveau dudit dispositif,
dans lequel chaque valeur mesurée I_{DDQ} est divisée par une valeur I_{DDQ} de référence ou une valeur I_{DDQ} mesurée précédemment, et dans lequel le résultat de ladite division est comparé à ladite référence I_{DDQ} relative prédéfinie, résultant en une décision de réussite ou d'échec pour ledit dispositif
**caractérisé en ce que** ledit courant d'alimentation de repos I_{DDQ} et ladite valeur I_{DDQ} précédente ou I_{DDQ} de référence par laquelle il est divisé, sont mesurés au sein du même dispositif.

2. Procédé selon la revendication 1, dans lequel ladite décision d'échec ou de réussite est prise sur la base de si oui ou non ledit résultat de ladite division est inclus dans une gamme de valeurs comportant ladite référence prédéfinie.

3. Procédé selon la revendication 1, dans lequel ladite référence I_{DDQ} relative est une référence relative à un vecteur.

4. Procédé selon la revendication 3, dans lequel ladite référence relative à un vecteur est obtenue par les étapes ci-dessous consistant à :
- prendre un échantillon de production aléatoire de dispositifs microélectroniques du même type,
- pour chaque dispositif de l'échantillon : mesurer la valeur I_{DDQ} pour un vecteur test de référence donné et mesurer la valeur I_{DDQ} pour chacun des autres vecteurs tests I_{DDQ},
- pour chaque dispositif de l'échantillon : calculer la valeur I_{DDQ} relative de chaque mesure I_{DDQ}, en divisant chaque mesure par la valeur I_{DDQ} relative au vecteur de référence choisi,
- pour chaque vecteur I_{DDQ}, pour tous les dispositifs de l'échantillon : déterminer la moyenne et le sigma des valeurs I_{DDQ} relatives,
- pour chaque vecteur I_{DDQ}, pour tous les dispositifs de l'échantillon : omettre toutes les mesures I_{DDQ} relatives éloignées (10),
- pour chaque vecteur I_{DDQ} : déterminer la moyenne et le sigma des valeurs I_{DDQ} relatives sans les mesures I_{DDQ} relatives éloignées, et obtenir par conséquent ladite référence relative à un vecteur.

5. Procédé selon la revendication 1, dans lequel ladite référence I_{DDQ} relative est égale à 1.

6. Procédé selon la revendication 1, dans lequel ladite référence I_{DDQ} relative est dérivée d'un graphique montrant le niveau I_{DDQ} mesuré maximum en fonction du niveau I_{DDQ} mesuré minimum, pour un nombre de dispositifs microélectroniques.

7. Procédé selon la revendication 1, dans lequel la valeur mesurée est également comparée à une référence I_{DDQ} absolue et la décision d'échec ou de réussite est un résultat combiné des deux comparaisons.

8. Procédé selon la revendication 1, comportant en outre l'étape consistant à comparer la valeur I_{DDQ} relative à une valeur minimale, ladite valeur minimale étant basée sur la théorie de l'appariement.
